# EUROPÄISCHE PATENTSCHRIFT

(11) **EP 0 295 547 B1**
(45) Veröffentlichungstag und Bekanntmachung des Hinweises auf die Patenterteilung: **01.06.1994**
(21) Anmeldenummer: 88109083.1
(22) Anmeldetag: 08.06.1988
(51) Int. Cl.: C08K 5/07, C08K 5/09, C08K 5/10, C08L 29/04, C08F 2/50, G03C 1/73

(54) **Durch Photopolymerisation vernetzbares Gemisch**
Composition curable by photopolymerization
Composition durcissable à l'aide de photopolymérisation

(30) Priorität: 13.06.1987 DE 3719844
(43) Veröffentlichungstag der Anmeldung: 21.12.1988
(73) Patentinhaber: BASF Aktiengesellschaft, 67063 Ludwigshafen (DE)
(72) Erfinder: Bronstert, Bernd, Dr., D-6701 Otterstadt (DE); Zuerger, Manfred, D-6920 Sinsheim (DE)

(56) Entgegenhaltungen:
- US-A- 4 043 819
- WPIL, File Supplier Derwent Publications Ltd., London GB; & JP-B-72-45412 (Kanzaki)

## Beschreibung

Die Erfindung betrifft ein neues, durch Photopolymerisation vernetzbares, in wäßrigen Medien lösliches oder dispergierbares Gemisch auf der Grundlage von Hydroxyl- und/oder Amidgruppen enthaltenden Polymerisaten als Bindemittel, hiermit verträglichen photopolymerisierbaren Monomeren und Initiatoren der Photopolymerisation.

Außerdem betrifft die Erfindung ein neues, mehrschichtiges, mit Wasser entwickelbares, lichtempfindliches Aufzeichnungsmaterial, welches mindestens eine Schicht aus dem neuen Gemisch enthält.

Für partiell oder nahezu vollständig hydrolysierte Homo- und Copolymerisate von Vinylalkohol-alkancarbonsäureestern und für Pfropfmischpolymerisate auf dieser Basis hat sich die Bezeichnung "Polyvinylalkohol" eingebürgert, welche im folgenden der Kürze halber verwendet wird. Die Alkencarbonsäureester, Alkencarbonvlamino-N-methylenether und Carbamylsäureester dieser Polyvinylalkohole werden im folgenden kurz als "Polyvinylalkoholderivate" bezeichnet. Dabei weist der Passus "partiell hydrolysiert" darauf hin, daß 40 bis 98 Mol.% der in den Polymerisaten ursprünglich vorhandenen Alkancarbonsäureestergruppen zu Hydroxigruppen hydrolysiert worden sind. Demgemäß bezeichnet der Passus "nahezu vollständig hydrolysiert" einen Hydrolysegrad von mehr als 98 Mol. %.

Komponenten von Gemischen werden dann als "verträglich" bezeichnet, wenn sie befähigt sind, ohne merkliche Trübung ineinander dispergiert zu bleiben.

Durch Photopolymerisation vernetzbare Gemische auf der Grundlage von Polyvinylalkoholen als Bindemittel, hiermit verträglichen photopolymerisierbaren Monomoren und Initiatoren der Photopolymerisation sind z.B. aus der DE-A-23 62 005 bekannt und dienen in der Hauptsache der Herstellung von durch Photopolymerisation vernetzbaren reliefbildenden Schichten mehrschichtiger, lichtempfindlicher Aufzeichnungsmaterialien.

Die bekannten Gemische weisen indes Nachteile auf. So werden durch Photopolymerisation vernetzte Haftlackschichten auf der Grundlage dieser bekannten Gemische bei der Entwicklung der bildmäßig belichteten Aufzeichnungsmaterialien mit Wasser stark geschädigt, was zum Ablösen von Bildelementen schon beim Entwickeln und erst recht beim späteren Drucken führt. Außerdem weisen reliefbildende Schichten aus diesen bekannten Gemischen nach ihrer bildmäßigen Belichtung und Entwicklung mit Wasser oftmals Schäden in Form kleiner Löcher auf, was allgemein als Lochfraß bezeichnet wird. Überdies kommt es zu Ouellschäden, und die Farbannahme der druckenden Bereiche ist häufig unzureichend. Werden solche Haftlackschichten und reliefbildenden Schichten gemeinsam in einem Aufzeichnungsmaterial verwendet, so verstärken sich die nachteiligen Effekte gegenseitig.

Man hat versucht, diese Nachteile durch die nachträgliche Behandlung der Oberfläche der belichteten und entwickelten Aufzeichnungsmaterialien der in Rede stehenden Art mit einem Aldehyd, wie Glyoxal oder Glyoxylsäure, zu beheben (vgl. DE-A-23 62 005). Diese Maßnahme macht zwar im Nachhinein die belichteten und entwickelten Aufzeichnungsmaterialien etwas beständiger gegenüber Wasser, sie löst aber nicht die übrigen Probleme, wie die mangelnde Haftfestigkeit der Haftlackschichten oder den Lochfraß in den reliefbildenden Schichten, welche bereits bei der Entwicklung auftreten.

Aus der US-A-4 043 819 war auch ein zur Herstellung stabiler polymerer Bilder geeignetes photopolymerisierbares Material bekannt, das aus ethylenisch ungesättigten, in Wasser oder Wasser/Alkohol-Gemischen löslichen Monomeren, einem bestimmten Diazin-Photoinitiator, einem quellfähigen Reaktionsprodukt aus makromolekularem in Wasser oder Wasser/Alkohol-Gemischen löslichen Bindemittel und einem Härter sowie gegebenenfalls einer chemisch inerten makromolekularen Substanz, die weder mit dem Bindemittel noch mit dem Härter reagiert, bekannt, wobei Gelatine, chemisch modifizierte Gelatine, Polyvinylalkohol und Maleinsäureanhydrid/Olefin-Copolymere als Bindemittel sowie Glyoxal und Glycerin als Härter genannt werden. Derartige Zusammensetzungen weisen jedoch eine unzureichende Überwaschresistenz auf und sind daher als Haft- und Reliefschicht wenig geeignet.

Aufgabe der vorliegenden Erfindung war es, anstelle der bekannten, durch Photopolymerisation vernetzbaren, in wäßrigen Medien löslichen oder dispergierbaren Gemische auf der Grundlage von Hydroxyl- und/oder Amidgruppen enthaltenden Polymerisaten als Bindemittel, hiermit vertraglichen, photopolymerisierbaren Monomeren und Initiatoren der Photopolymerisation neue, in ihren anwendungstechnischen Eigenschaften verbesserte Gemische dieser Art aufzuzeigen, welche sich für die Herstellung neuer, mehrschichtiger, mit wäßrigen Medien entwickelbarer, lichtempfindlicher Aufzeichnungsmaterialien eignen, die die Nachteile der vom Stand der Technik her bekannten Aufzeichnungsmaterialien nicht länger aufweisen.

Außerdem war es Aufgabe der Erfindung, neue, verbesserte, mit wäßrigen Medien entwickelbare, lichtempfindliche Aufzeichnungsmaterialien der in Rede stehenden Art aufzuzeigen, welche keinen Lochfraß und keine Haftungsmängel mehr aufweisen.

Demgemäß wurde ein durch Photopolymerisation vernetzbares, in wäßrigen Medien lösliches oder dispergierbares Gemisch auf der Grundlage von Hydroxyl- und/oder Amidgruppen enthaltenden Polymerisaten als Bindemittel, hiermit verträglichen, photopolymerisierbaren Monomeren und Initiatoren der Photopolymerisation gefunden, welches dadurch gekennzeichnet ist, daß es als Bindemittel zu 75 bis 95 % hydrolysierte Polyvinylalkoholalkancarbonsäureester und/oder partiell oder nahezu vollständig hydrolysierte Vinylalkohol-alkancarbonsäureester/Alkylenoxid-Pfropfmischpolymerisate sowie, bezogen auf die Gesamtmenge des Gemisches, 0,10 bis 10 Gew.-% eines Aldehydes der allgemeinen Formel I enthält, 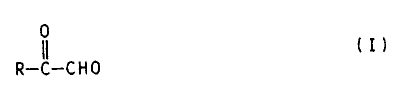
worin R ein Wasserstoffatom. eine Hydroxylgruppe oder einen C₁-C₆-Alkyl-, C₁-C₆-Alkoxi-, C₆-C₁₀-Aryl- oder einen C₆-C₁₀-Aryloxirest bedeutet.

Außerdem wurde ein mehrschichtiges, mit wäßrigen Medien entwickelbares, lichtempfindliches Aufzeichnungsmaterial gefunden, welches mindestens eine Schicht aus dem erfindungsgemäßen Gemisch enthält.

Unter "Gesamtmenge" des erfindungsgemäßen Gemisches ist dabei vorstehend, wie auch im folgenden, die Summe aus den Mengen des polymeren Bindemittels, der photopolymerisierbaren Monomeren, des Photopolymerisationsinitiators und des Aldehyds der Formel I zu verstehen.

Beispiele erfindungsgemäß anzuwendender Aldehyde der allgemeinen Formel I sind Glyoxal, Glyoxylsäure, aliphatische α-Ketoaldehyde wie 2-Oxopropanal, 2-Oxobutanal oder 2-Oxahexanal; aliphatische Glyoxylsäureester wie Glyoxylsäuremethyl-, -ethyl-, -pentyl- oder -hexylester; araliphatische α-Ketoaldehyde wie 3-Phenyl-2-oxopropanal oder 3-(4'-Methylphenyl)-2-oxopropanal; oder aromatische Glyoxylsäureester wie Glyoxylsäurephenylester. Von diesen Aldehyden sind Glyoxal, Glyoxylsäure und Glyoxylsäuremethylester bevorzugt, wobei Glyoxal von besonderem Vorteil ist.

Die erfindungsgemäßen Gemische enthalten, bezogen auf ihre Gesamtmenge, 0,1 bis 10 Gew.%. vorzugsweise 0,3 bis 6 Gew. % und insbesondere 0,5 bis 4 Gew.% dieser Aldehyde.

Für die Herstellung der erfindungsgemäßen Gemische sind an und für sich alle zu 75 bis 95 % hydrolysierten Polyvinylalkoholalkancarbonsäureester und/oder partiell oder nahezu vollständig hydrolysierten Vinylalkohol-alkancarbonsäureester/Alkylenoxid-Pfropfmischpolymerisate geeignet, sofern sie Hydroxyl- und/oder Amidgruppen aufweisen und in wäßrigen Medien löslich oder dispergierbar sind.

Unter "wäßrigen Medien" sind neben Wasser selbst sowohl Lösungen von Gasen sowie von organischen oder anorganischen Feststoffen in Wasser, als auch Gemische von Wasser oder von solchen wäßrigen Lösungen mit anderen, vorwiegend organischen Lösungsmitteln, zu verstehen.

Beispiele geeigneter wäßriger Medien sind Wasser, wäßriges Ammoniak, Natronlauge, Kalilauge. wäßriges Triethylamin, Lösungen von Tensiden wie Alkylsulfonaten in Wasser, Ethanol-, Isopropanol-, n-Butanol- oder Aceton-Wasser-Gemische oder Gemische solcher Alkohole und Ketone mit wäßrigem Ammoniak oder Natronlauge. Von besonderem Vorteil ist hierbei Wasser.

Von besonderem Vorteil sind hierbei die in Wasser löslichen oder dispergierbaren Polyvinylalkohole, welche wiederkehrende 1-Hydroxi-ethyliden-1,2-Einheiten 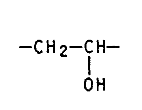
in der Polymerkette enthalten und zahlenmittlere Molgewichte M̅ₙ von 10⁴ bis 10⁵, insbesondere 1,5·10⁴ bis 5·10⁴ aufweisen, beispielsweise partiell oder nahezu vollständig hydrolysiertes Polyvinylacetat oder -propionat mit einem Hydrolysegrad von 75 bis 95 %.

Von besonderem Vorteil sind auch die partiell oder nahezu vollständig hydrolysierten Vinylalkohol-alkancarbonsäureester/Alkylenoxid-Pfropfmischpolymerisate, insbesondere solche, die durch Pfropfen von Vinylacetat oder -propionat auf Polyethylenoxid und anschließende Hydrolyse erhalten werden und aus - jeweils bezogen auf das Pfropfmischpolymerisat -
10 bis 30 Gew.% an 1-Oxapropyliden-1,3-

-O-CH₂-CH₂-

0 bis 30 Gew.% an 1-Acetyl-ethyliden-1,2- 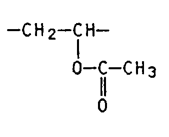
und 90 bis 40 Gew.% an 1-Hydroxiethyliden-1,2-Einheiten bestehen.

Die Polyvinylalkoholderivate enthalten, bezogen auf die ursprünglich in den Polyvinylalkoholen vorhandenen Hydroxylgruppen, 0,1 bis 10, vorzugsweise 0,5 bis 8 und insbesondere 1 bis 6 Mol.% der durch übliche und bekannte polymeranaloge Umsetzungen eingeführten seitenständigen Alkencarbonsäureesterreste wie Acryl-, Methacryl- oder Maleinsäureesterreste; oder der Alkencarbonylamino-N-methylenetherreste wie Acryl- oder Methacrylamido-N-methylenetherreste; oder der Carbamylesterreste.

Vorteilhafterweise enthalten die erfindungsgemäßen Gemische, bezogen auf ihre Gesamtmenge, 30 bis 89,89 Gew.%, vorzugsweise 35 bis 79,6 Gew.% und insbesondere 40 bis 74 Gew.% dieser Bindemittel.

Für die Herstellung der Gemische kommen solche Monomeren in Betracht, welche photopolymerisierbar und mit den Bindemitteln verträglich sind. Geeignete Monomere dieser Art weisen im allgemeinen einen Siedepunkt von über 100°C auf. Üblicherweise haben sie ein Molekulargewicht von weniger als 3000, orzugsweise von weniger als 2000.

Beispiele geeigneter Monomerer sind die Ester der Acrylsäure und/oder Methacrylsäure mit ein- oder mehrwertigen Alkoholen, z.B. Butylacrylat, Butylmethacrylat, 2-Ethylhexylacrylat, Lauryl(meth)acrylat, Ethylenglykol-di(meth)acrylat, Butandiol-1,4-di(meth)acrylat, Neopentylglykol-di(meth)acrylat, 3-Methylpentandiol-di(meth)acrylat, 2-Hydroxypropyl(meth)acrylat, 2-Hydroxyethyl(meth)acrylat, Hexandiol-1,6-di(meth)acrylat, 1,1,1-Trimethylolpropantri(meth)acrylat, Di-, Tri- und Tetraethylenglykoldi(meth)acrylat, Tripropylenglykol-di(meth)acrylat, Pentaerythrit-tetra(meth)acrylat oder 3,12-Dihydroxy-1,5,10,14-tetraoxatetradec-1,14-yl-di(meth)acrylat. Außerdem kommen die Vinylester aliphatischer Monocarbonsäuren wie Vinyloleat; Divinylether von Alkoholen wie Octadecylvinylether und Butandiol-1,4-divinylether; die Diester von Fumar- und Maleinsäure; oder die Umsetzungsprodukte aus OH-terminierten Oligobutadienen mit Maleinsäure und/oder Methacrylsäure in Betracht. Überdies sind Alkencarbonylamino-N-methylenether wie Ethylenglykol-bis-, Propandiol-bis-, Butandiol-bis-, Diethylenglykol-bis-, Glycerol-bis- oder -tris- oder Pentaerythritoltetrakis(methacrylamido-N-methylen)ether oder die entsprechenden Acrylamido-N-methylenether geeignet. Von diesen Monomeren sind 3,12-Dihydroxy-1,5,10,14-tetraoxatetradec-1,14-yl- und Ethylenglykol-bis-, Glycerol-bis-oder Glycerol-tris(methacrylamido-N-methylen)ether besonders vorteilhaft.

Die erfindungsgemäßen Gemische enthalten, bezogen auf ihre Gesamtmenge, 10 bis 50, vorzugsweise 20 bis 45 und insbesondere 25 bis 40 Gew.% der Monomeren.

Die erfindungsgemäßen Gemische enthalten übliche und bekannte Initiatoren der Photopolymerisation in einer Menge von 0,01 bis 10, vorzugsweise 0,1 bis 8 und insbesondere 0,5 bis 5 Gew.%, bezogen auf ihre Gesamtmenge.

Beispiele für geeignete Photoinitiatoren sind Benzoin oder Benzoinderivate wie dessen Methyl-, Isopropyl-, n-Butyl- oder Isobutylether; symmetrisch oder unsymmetrisch substituierte Benzilacetale wie Benzildimethylacetal oder Benzil-1-methyl-1-ethyl-acetal; Acyldiarylphosphinoxide und Acylarylphosphinsäurederivate wie 2,6-Dimethoxibenzoyl-diphenylphosphinoxid, 2,4,6-Trimethylbenzoyl-diphenylphosphinoxid, 2,4,6-Trimethylbenzoylphenylphosphinsäure-Natriumsalz oder 2,4,6-Trimethylbenzoyl-phenylphosphinsäureethylester; oder substituierte und unsubstituierte Chinone wie Ethylanthrachinon, Benzanthrachinon, Benzophenon oder 4,4'-Bis(dimethylamino)benzophenon. Sie können allein oder im Gemisch miteinander verwendet werden.

Darüber hinaus können die erfindungsgemäßen Gemische noch weitere Zusatzstoffe wie Inhibitoren der thermischen Polymerisation` Weichmacher, Antiozonantien, Farbstoffe, Pigmente, photochrome Zusätze, Reduktionsmittel, Mittel zur Verbesserung der Reliefstruktur, Antioxidantien, Füllstoffe, Verstärkerfüllstoffe, Flußmittel, Formtrennmittel, Vernetzungshilfsmittel, klebrig-machende Harze und Kautschuke enthalten. Diese Zusatzstoffe können für sich alleine oder in Mischung miteinander in Mengen von bis zu 100 Gew.%, bezogen auf die Gesamtmenge des erfindungsgemäßen Gemischs, zugesetzt werden.

Die Herstellung der erfindungsgemäßen Gemische aus den einzelnen Komponenten weist keine methodischen Besonderheiten auf, sondern es können die üblichen Knet-, Misch- oder Lösungstechniken für das Vermischen der Komponenten angewendet werden.

Die so erhaltenen erfindungsgemäßen Gemische können mit Vorteil bei der Herstellung von mehrschichtigen, mit wäßrigen Medien entwickelbaren lichtempfindlichen Aufzeichnungsmaterialien verwendet werden. Dazu werden sie in üblicher Weise durch Gießen aus einer Lösung, Heißpressen, Kalandrieren oder Extrudieren zu Schichten der gewünschten Dicke geformt. Die Dicke der Schichten richtet sich in erster Linie danach, ob sie als reliefbildende Schichten oder als Haftlackschichten verwendet werden sollen. Die Dicke der reliefbildenden Schichten wiederum richtet sich nach dem Anwendungszweck der lichtempfindlichen Aufzeichnungsmaterialien und variiert im allgemeinen von 0,001 bis 0,8 mm, wogegen die Haftlackschichten üblicherweise 0,0005 bis 0,1 mm dick sind.

Die erfindungsgemäßen mehrschichtigen, mit wäßrigen Medien entwickelbaren, lichtempfindlichen Aufzeichnungsmaterialien enthalten entweder eine reliefbildende Schicht oder eine Haftlackschicht aus einem erfindungsgemäßen Gemisch. Von ganz besonderem Vorteil sind indes solche Aufzeichnungsmaterialien, deren reliefbildende Schicht und Haftlackschicht aus den erfindungsgemäßen Gemischen bestehen.

Üblicherweise ist die reliefbildende Schicht der Aufzeichnungsmaterialien mit einem dimensionsstabilen Träger haftfest verbunden. Außerdem kann auf die dem Träger abgewandte Seite der reliefbildenden Schicht eine Deckschicht und/oder eine Deckfolie aufgebracht werden.

Werden Deckschicht und Deckfolie gemeinsam verwendet, dann liegt die Deckschicht der reliefbildenden Schicht direkt auf, und es kann sich zwischen Deckschicht und Deckfolie noch eine Antihaftschicht befinden. Ferner kann eine haftfeste Verbindung zwischen der reliefbildenden Schicht und der Deckfolie mit Hilfe einer Haftschicht erzielt werden.

Als dimensionsstabile Träger werden üblicherweise Platten, Folien oder Zylinderhülsen (sleeves) aus Metallen, wie insbesondere Stahl, Aluminium, Kupfer oder Nickel, oder aus Hochpolymeren, wie z.B. Polyethylenterephthalat. Polybutylenterephthalat, Polyamid oder Polycarbonat verwendet. Daneben kommen auch Gewebe und Vliese, wie Glasfasergewebe, oder Verbundmaterialien aus beispielsweise Glasfasern und Hochpolymeren, wie z.B. Polyethylenterephthalat, als Träger in Betracht.

Als Haftlackschichten können übliche und bekannte, im allgemeinen 0,0005 bis 0,1 mm dicke Haftlackschichten verwendet werden. Von Vorteil sind indes Haftlackschichten aus den erfindungsgemäßen Gemischen. Diese Haftlackschichten werden entweder vor dem Auftragen der reliefbildenden Schicht durch eine vollflächige Belichtung durch Photopolymerisation oder durch eine Wärmebehandlung thermisch oder nach dem Auftragen der reliefbildenden Schicht durch Photopolymerisation vernetzt. Der Vernetzung vor dem Auftragen der reliefbildenden Schicht wird dabei der Vorzug gegeben.

Übliche Deckschichten sind 0,5 bis 20 µm dick und können aus einem Polymeren bestehen, welches lösliche, klebfreie, transparente und reißfeste Filme bildet, z.B. Polyamid, Copolyamid, Polyurethan, Polyvinylalkohol, Polyvinylpyrrolidon, Polyethylenoxid eines Molgewichts von über 105 oder Cyclokautschuk mit einem hohen Cyclisierungsgrad. Gegebenenfalls kann die Deckschicht mattiert sein.

Übliche Deckfolien sind 20 bis 150 µm dick und bestehen aus einem Polymeren wie Polyamid oder Polyethylenterephthalat.

Übliche Antihaftschichten sind 0,1 bis 0,5 µm dick und bestehen beispielsweise aus Silikonharzen.

Werden als Träger stark reflektierende Platten oder Folien verwendet, dann können sie übliche Lichthofschutzmittel, wie Ruß oder Mangandioxid oder migrationsechte Farbstoffe oder Pigmente, enthalten. Die Lichthofschutzmittel können aber auch als separate Schicht auf dem Träger aufliegen oder in der Haftlackschicht oder der reliefbildenden Schicht enthalten sein.

Die Herstellung der mehrschichtigen, mit wäßrigen Medien entwickelbaren, lichtempfindlichen Aufzeichnungsmaterialien weist keine methodischen Besonderheiten auf. Üblicherweise erfolgt sie durch Auftragen der reliefbildenden Schicht auf den mit einer Haftlackschicht versehenen Träger mittels Gießen aus Lösung, Heißpressen, Kalandrieren oder Extrudieren. Auf ein solches Aufzeichnungsmaterial können dann die anderen Schichten in bekannter Weise aufgebracht werden. Es ist aber auch möglich, die reliefbildende Schicht zuerst auf die mit einer Deckschicht bedeckte Seite einer Deckfolie aufzutragen und anschließend die unbedeckte Seite der reliefbildenden Schicht mit dem Träger haftfest zu verbinden.

Aus den mehrschichtigen, mit wäßrigen Medien entwickelbaren, lichtempfindlichen Aufzeichnungsmaterialien können in üblicher Weise durch Photopolymerisation vernetzte Druckplatten und Photoresists hergestellt werden. Die Herstellung bietet keine methodischen Besonderheiten, sondern erfolgt - gegebenenfalls nach einer Vorbehandlung - durch bildmäßiges Belichten der Aufzeichnungsmaterialien mit aktinischem Licht einer Wellenlänge λ zwischen 300 und 450 nm, vorteilhafterweise zwischen 320 und 400 nm, durch aufgelegte Negativ-Vorlagen hindurch, Auswaschen der unbelichteten und daher unvernetzten Anteile der Druckplatten und Photoresists mit wäßrigen Medien und Trocknen der in dieser Weise erhaltenen, durch Photopolymerisation vernetzten Druckplatten und Photoresists, welche nun eine Reliefschicht enthalten.

Übliche Vorbehandlungen sind z.B. das Abziehen einer gegebenenfalls in dem lichtempfindlichen Aufzeichnungsmaterial vorhandenen Deckfolie oder die vollflächige Belichtung der reliefbildenden Schicht und/oder der Haftlackschicht mit aktinischem Licht von der Rückseite, d.h. von derjenigen Seite her, die der druckenden Fläche abgewandt ist.

Geeignete Lichtquellen für aktinisches Licht sind z.B. handelsübliche UV-Fluoreszenzröhren, Ouecksilbermittel-, -hoch- und -niederdruckstrahler, superaktinische Leuchtstoffröhren, Xenonimpulslampen, mit Metalliodiden dotierte Lampen oder Kohlebogenlampen.

Eine übliche Nachbehandlung ist das vollflächige Nachbelichten der durch Photopolymerisation vernetzten Druckplatten und Photoresists.

Die Dicke der Reliefschicht der belichteten und entwickelten mehrschichtigen Aufzeichnungsmaterialien variiert je nach Verwendungszweck von 0,001 bis 0,8 mm.

Die in bekannter Weise erhaltenen, durch Photopolymerisation vernetzten Druckplatten auf der Grundlage der erfindungsgemäßen Gemische können in üblicher Weise auf Druckzylinder aufgebracht und für den Endlosdruck verwendet werden.

Die erfindungsgemäßen Gemische weisen bei ihrer Herstellung, Verarbeitung und Verwendung besondere unerwartete Vorteile auf, welche sie vom Stand der Technik abheben. So sind bei ihrer Herstellung keine besonderen Maßnahmen zu ergreifen, sondern es können die für solche Gemische üblichen und bekannten Herstellmethoden verwendet werden. Aufgrund ihrer hohen thermischen Stabilität lassen sie sich sehr leicht nach den üblichen Verfahren zu den unterschiedlichsten Produkten verarbeiten, ohne daß hierzu besondere Vorsichtsmaßnahmen zu ergreifen sind. Sie sind von hervorragender Lagerstabilität und sie lassen sich umweltfreundlich entsorgen, was in der betrieblichen Praxis von großem Vorteil ist. Im Hinblick auf den Stand der Technik ist gerade die Lagerstabilität überraschend, weil eigentlich zu erwarten stand, daß die Gemische vorzeitig vernetzen würden.

Die mehrschichtigen, mit wäßrigen Medien entwickelbaren, lichtempfindlichen Aufzeichnungsmaterialien auf der Grundlage der erfindungsgemäßen Gemische zeigen gleichfalls besondere unerwartete technische Effekte.

So geben ihre reliefbildenden Schichten aus den erfindungsgemäßen Gemischen auch die feinsten Bildelemente von Bildvorlagen in hervorragender Qualität wieder. Besonders hervorzuheben ist die Güte der aus diesen reliefbildenden Schicht durch Belichten und Entwickeln hergestellten Reliefschichten. Diese weisen eine hohe Härte, eine sehr geringe Wasserempfindlichkeit und eine vorzügliche Farbannahme auf. Insbesondere zeigen diese Reliefschichten keine Ouellschäden und keinen Lochfraß mehr, und eine zusätzliche Nachbehandlung mit Aldehyden ist nicht mehr länger notwendig. Beim Drucken mit diesen Reliefschichten werden sehr hohe Auflagen erreicht, ohne daß es zum Ablösen von Reliefteilen kommt. Überdies weisen auch mehr als 0,8 mm dicke reliefbildende Schichten aus den erfindungsgemäßen Gemischen nach wie vor sehr gute Belichtungseigenschaften auf, so daß Aufzeichnungsmaterialien, welche diese dicken Schichten enthalten, für die Herstellung von Heißprägematrizen in Betracht kommen.

Haftlackschichten auf der Grundlage der erfindungsgemäßen Gemische haben den Vorteil, daß sie nicht nur durch Photopolymerisation, sondern auch durch Wärmeeinwirkung vernetzt werden können. Dadurch kann das anwendungstechnische Eigenschaftsprofil der Haftlackschichten noch besser sowohl auf den Träger als auch auf die reliefbildende Schicht abgestimmt werden, wodurch die Haftfestigkeit der Haftlackschichten in vorteilhafter Weise leicht optimiert werden kann. Die thermisch und/oder photovernetzten Haftlackschichten können daher Probleme der Haftung von reliefbildenden Schichten unterschiedlichster Zusammensetzung auf Trägern aus den verschiedensten Materialien lösen. Die vernetzten Haftlackschichten sind äußerst quellbeständig und wasserunempfindlich. Druckformen, welche diese Haftlackschichten enthalten, sind besonders dimensionsstabil, farbfest und abriebbeständig; und auch nach sehr hohen Druckauflagen kommt es nicht zum Ablösen von Reliefteilen.

Ganz besondere Vorteile ergeben sich, wenn man reliefbildende Schichten und Haftlackschichten auf der Grundlage der erfindungsgemäßen Gemische gemeinsam verwendet. Dadurch resultieren Aufzeichnungsmaterialien, in welchen sich die vorstehend genannten besonderen technischen Effekte gegenseitig verstärken. Hierbei ist vor allem die in der Praxis äußerst hinderliche Überwaschempfindlichkeit der bekannten Aufzeichnungsmaterialien zu nennen, welche bei den neuen Materialien nicht mehr auftritt.

### Beispiele

### Beispiel 1

Herstellung eines mehrschichtigen, mit wäßrigen Medien entwickelbaren, lichtempfindlichen Aufzeichnungsmaterials mit einer reliefbildenden Schicht aus einem erfindungsgemäßen Gemisch; Herstellvorschrift:
Auf ein 240 µm dickes Stahlblech wurde zunächst eine 10 µm Grundierlackschicht aus einem üblichen und bekannten Polyurethan aufgetragen. Auf die Grundierlackschicht wurde eine 20 %ige Lösung eines partiell hydrolysierten Polyvinylacetats (Hydrolysegrad: 80 Mol. %, zahlenmittleres Molekulargewicht M̅ₙ: 2,5·10⁴) in einem Methanol/Wasser-Gemisch (Volumenverhältnis 1:1) so aufgegossen, daß nach 3 minütiger Trocknung bei 150°C eine 10 µm dicke Oberlackschicht resultierte.

Für die Herstellung der reliefbildenden Schicht wurde eine 30 %ige Lösung aus
30 Gew.-Teilen eines Polyvinylalkoholderivats mit Methacrylsäureesterresten (Hydrolysegrad: 80 Mol.%. zahlenmittleres Molekulargewicht M̅ₙ: 2,5·10⁴, Gehalt an Methacrylsäureesterresten: 5 Mol.%),
39 Gew.-Teilen eines Polyvinylalkohols (Hydrolysegrad: 80 Mol.%, zahlenmittleres Molekulargewicht M̅ₙ: 2,5·10⁴),
26 Gew.-Teilen 3,12-Dihydroxy-1,5,10,14-tetraoxatetradecyl-1,14-diacrylat,
2 Gew.-Teilen Benzildimethylacetal,
0,5 Gew.-Teilen Cyclohexyldiaceniumdioxikalium-Salz,
0,02 Gew.-Teilen Safranin O (C.I. 50240) und
2 Gew.-Teilen Glyoxal
in Wasser/n-Propanol (Volumenverhältnis 1:1) hergestellt. Diese Lösung konnte längere Zeit bei Zimmertemperatur gelagert werden, ohne daß es dabei zu einer Gelbildung oder zu einer Entmischung kam.

Die Lösung wurde auf die Oberlackschicht des Stahlblechs so aufgegossen, daß nach 10 minütiger Trocknung bei 90°C Lufttemperatur eine 35 µm dicke reliefbildende Schicht resultierte.

Die in dieser Weise hergestellte, durch Photopolymerisation vernetzbare Druckplatte wurde zuerst während 60 Sekunden durch ein autotypisch aufgerastertes Filmnegativ und dann während weiteren 60 Sekunden durch ein Kreuzlinienrasternegativ des Tonwertes 30 % und der Rasterlinienweite 32 Linien/cm hindurch belichtet. Als Lichtquelle diente ein handelsüblicher Druckplattenbelichter, welcher mit superaktinischen Leuchtstoffröhren ausgestattet war. Die bildmäßig belichtete Druckplatte wurde wie eine Offset-Druckplatte durch Abreiben mit Wasser unter Zuhilfenahme eines Plüschtampons bei Raumtemperatur während 40 Sekunden entwickelt. Die entwickelte Druckplatte wurde in einem Umlufttrockenschrank während 10 Minuten bei 80°C getrocknet.

Das so hergestellte Druckklischee zeigte keinerlei Quellschäden durch den Entwicklungsschritt. In einer Tampondruckmaschine konnten von dem Klischee 40.000 Drucke einwandfreier Qualität hergestellt werden, ohne daß es zu Ausbrüchen oder anderen Abnutzungserscheinungen des Klischee-Reliefs kam.

### Vergleichsversuch A

Herstellung eines mehrschichtigen, mit wäßrigen Medien entwickelbaren, lichtempfindlichen Aufzeichnungsmaterials mit einer reliefbildenden Schicht aus einem bekannten Gemisch; Herstellvorschrift:
Es wurde im wesentlichen wie im Beispiel 1 verfahren, nur daß die reliefbildende Schicht kein Glyoxal enthielt. Nach der bildmäßigen Belichtung und Entwicklung wies das Klischee in den Volltonflächen und in den feinen Rasterstegen Beschädigungen in Form kleiner Löcher (Lochfraß) und verzogener und abgelöster Rasterstege auf. Dieses Klischee war für den Druck auf einer Tampondruckmaschine nicht geeignet.

### Beispiel 2

Herstellung eines mehrschichtigen, mit wäßrigen Medien entwickelbaren, lichtempfindlichen Aufzeichnungsmaterials mit einer reliefbildenden Schicht aus einem erfindungsgemäßen Gemisch; Herstellvorschrift:
Es wurde im wesentlichen wie im Beispiel 1 verfahren, nur daß die reliefbildenden Schicht statt 35 µm 150 µm dick war. Für die Trocknung dieser Schicht benötigte man 30 Minuten. Für die bildmäßige Belichtung wurde ein Filmnegativ mit autotypisch aufgerasterten Bildern verwendet, so daß anstelle eines Klischees mit Näpfchen - wie es für Tief- oder Tampondruck benötigt wird - ein solches mit einem Druckrelief - wie es für den normalen oder auch den indirekten Hochdruck (Letterset-Druck) benötigt wird - erhalten wurde. Die bildmäßig belichtete Druckplatte wurde während 60 Sekunden in einem handelsüblichen Reibewascher bei 30°C mit Wasser entwickelt. Es wurde ein ausgezeichnetes Klischee mit gut ausgebildeten 50 µm breiten Linien und 3 %igen Rastertonwertfeldern der Rasterlinienweite 32 Linien/cm erhalten. Weder die Rasterfelder noch die Linien wiesen an den Kanten Ablösungen oder andere Quellschäden auf, welche üblicherweise beim oder nach dem Auswaschprozess durch Einwirkung von Wasser entstehen.

### Vergleichsversuch B

Herstellung eines mehrschichtigen, mit wäßrigen Medien entwickelbaren, lichtempfindlichen Aufzeichnungsmaterials mit einer reliefbildenden Schicht aus einem bekannten Gemisch; Herstellvorschrift:
Es wurde im wesentlichen wie im Beispiel 2 gearbeitet, nur daß die reliefbildenden Schicht kein Glyoxal enthielt. Zwar konnte die bildmäßig belichtete Druckplatte binnen 40 Sekunden ausgewaschen werden, es wurde jedoch kein brauchbares Klischee erhalten, weil die Linien- und Rasterfelder Quellschäden aufwiesen und Teile des Reliefs vom Trägerblech abgelöst waren.

### Beispiel 3

Herstellung eines mehrschichtigen, mit wäßrigen Medien entwickelbaren, lichtempfindlichen Aufzeichnungsmaterials mit einer reliefbildenden Schicht aus einem erfindungsgemäßen Gemisch; Herstellvorschrift:
Es wurde im wesentlichen wie im Beispiel 1 verfahren, nur daß als Trägerblech ein elektrochemisch aufgerauhtes und anodisiertes Offset-Trägerblech aus Aluminium angewendet wurde. Außerdem wurde, um die gewünschte Trockenschichtdicke der reliefbildenden Schicht von 3 µm zu erzielen, der Feststoffgehalt der Gießlösung auf 10 % verringert und das Naßauftragsgewicht erniedrigt. Nach der Belichtung gemäß Beispiel 2 und dem Auswaschen in Leitungswasser wurde ein Offset-Klischee erhalten, welches beim Einreiben mit einer Farb/Wasser-Emulsion vom Typ "Öl-in-Wasser" nur an den belichteten Schichtbereichen die ölige Druckfarbe annahm und von dem in einer Offset-Druckmaschine Drucke hervorragender Qualität in hoher Auflage hergestellt werden konnten.

### Vergleichsversuch C

Herstellung eines mehrschichtigen, mit wäßrigen Medien entwickelbaren, lichtempfindlichen Aufzeichnungsmaterials mit einer reliefbildenden Schicht aus einem bekannten lichtempfindlichen Gemisch; Herstellvorschrift:
Es wurde im wesentlichen wie im Beispiel 3 verfahren, jedoch enthielt die reliefbildende Schicht kein Glyoxal. Beim Einreiben des belichteten, entwickelten und getrockneten Offset-Klischees mit einer üblichen und bekannten Farb/Wasser-Emulsion vom Typ "Öl-in-Wasser" nahm das Klischee an den belichteten Bildbereichen die Druckfarbe nur unzureichend an, so daß mit Hilfe dieses Klischees nicht gedruckt werden konnte.

### Beispiel 4

Herstellung einer Haftlackschicht aus dem erfindungsgemäßen Gemisch; Herstellvorschrift:
Auf eine 300 µm dicke Polyethyleneterephthalat-Folie, welche mit einer 10 µm dicken Grundierlackschicht aus einem üblichen und bekannten Polyurethan beschichtet war, wurde eine 35 %ige Lösung aus
30 Gew.-Teilen eines Polyvinylalkoholderivats mit seitenständigen Methacryl-säureesterresten (Hydrolysegrad: 80 Mol.%, zahlenmittleres Molekulargewicht M̅ₙ: 2,5·10⁴, Gehalt an Methacrylsäureesterresten: 5 Mol.%),
30 Gew.-Teilen eines Polyvinylalkohols (Hydrolysegrad: 80 Mol.%, zahlenmittleres Molekulargewicht M̅ₙ: 2,5·10⁴),
30 Gew.-Teilen Ethylenglykol-bis(acrylamido-N-methylen)ether,
8 Gew.-Teilen N-n-Butyl-benzolsulfonsäureamid,
2 Gew.-Teilen Benzildimethylacetal und
2 Gew.-Teilen Glyoxal
in Wasser/n-Propanol (Volumenverhältnis 3:1) so aufgerakelt, daß nach 20 minütiger Trocknung bei 90°C eine 50 µm dicke Haftlackschicht resultierte.

Die Haftlackschicht wurde während 5 Minuten mit aktinischem Licht vollflächig belichtet.

Unterzog man die durch Photopolymerisation vernetzte Haftlackschicht einem Waschtest bei 40°C in einem Düsenwascher bei einem Düsendruck von 4 bar, so wurde sie erst nach einer Waschzeit von 20 Minuten zerstört.

### Vergleichsversuch D

Herstellung einer Haftlackschicht aus einem bekannten lichtempfindlichen Gemisch; Herstellvorschrift:
Es wurde im wesentlichen wie im Beispiel 4 verfahren, nur daß die Haftlackschicht kein Glyoxal enthielt. Die durch Photopolymerisation vollflächig vernetzte Haftlackschicht wurde beim Waschtest bereits nach 5 minuten völlig zerstört.

### Beispiel 5

Herstellung eines mehrschichtigen, mit wäßrigen Medien entwickelbaren, lichtempfindlichen Aufzeichungsmaterials mit einer Haftlackschicht aus einem erfindungsgemäßen Gemisch; Herstellvorschrift:
Auf ein 240 µm dickes Stahlblech, welches mit einer 10 µm dicken Grundierlackschicht aus einem üblichen und bekannten Polyurethan beschichtet war, wurde eine 30 %ige Lösung aus
30 Gew.-Teilen eines Polyvinylalkoholderivats mit seitenständigen Methacryl-Säureesterresten (Hydrolysegrad: 80 Mol.%, zahlenmittleres Molekulargewicht M̅ₙ: 2,5·10⁴, Gehalt an Methacrylsäureesterresten: 5 Mol.%),
40 Gew.-Teilen eines Polyvinylalkohols (Hydrolysegrad: 80 Mol.%, zahlenmittleres Molekulargewicht M̅ₙ: 2,5·10⁴),
26 Gew.-Teilen Ethylenglykol-bis(acrylamido-N-methylen)ether,
2 Gew.-Teilen Benzildimethylacetal und
2 Gew.-Teilen Glyoxal
in Wasser/n-Propanol (Volumenverhältnis 3:1) so aufgegossen, daß nach 10 minütiger Trocknung bei 80°C eine 10 bis 12 µm dicke Haftlackschicht resultierte.

Die Haftlackschicht wurde während 15 Sekunden mit einem Röhrenbelichter, welcher mit handelsüblichen superaktinischen Leuchtstoffröhren bestückt war, vollflächig belichtet.

Zur Herstellung der reliefbildenden Schicht wurde auf die durch Photopolymerisation vollflächig vernetzte Haftlackschicht eine 60 %ige wäßrige Lösung eines Gemisches aus
30 Gew.-Teilen eines Polyvinylalkohols ((Hydrolysegrad: 80 Mol.%, zahlenmittleres Molekulargewicht M̅ₙ: 2,5·10⁴)
30 Gew.-Teilen eines Polyvinylalkoholderivats mit seitenständigen Methacryl-säureesterresten (Hydrolysegrad: 80 Mol.%, zahlenmittleres Molekulargewicht M̅ₙ: 2,5·10⁴, Gehalt an Methacrylsäureesterresten: 6 Mol.%),
35 Gew.-Teilen Glycerol-bis(acrylamido-N-methylen)ether,
5 Gew.-Teilen N-n-Butylbenzolsulfonsäureamid,
2 Gew.-Teilen Benzoin-i-propylether und
0,5 Gew.-Teilen Cyclohexyldiazeniumdioxikalium-Salz
in Wasser so aufgegossen, daß nach der Trocknung eine reliefbildende Schicht von 200 µm Dicke und einem Restwassergehalt von etwa 6 Gew.% resultierte.

Die in dieser Weise hergestellte Druckplatte wurde durch ein Filmnegativ hindurch während 60 Sekunden mittels eines Druckplattenbelichters, welcher als Lichtquelle einen eisendotierten Quecksilbermitteldruckstrahler aufwies, belichtet. Die bildmäßig belichtete Druckplatte wurde anschließend 70 Sekunden lang in einem Spühwascher bei einem Sprühdruck von 40 mPas entwickelt.

Das so erhaltene Klischee mit einer Reliefhöhe von 200 µm war hervorragend für den Druck geeignet. Es wurden ausgezeichnete Drucke erhalten, bei denen auch die feinsten Bilddetails gehalten wurden. Selbst eine Überwaschung von 100 % bei der Entwicklung wurde von dem Klischee ohne Qualitätsverlust verkraftet; es waren keinerlei Ablösungen von Reliefteilen zu beobachten.

### Vergleichsversuch E

Herstellung eines mehrshichtigen, mit wäßrigen Medien entwickelbaren, lichtempfindlichen Aufzeichnungsmaterials mit einer Haftlackschicht aus einem bekannten lichtempfindlichen Gemisch; Herstellvorschrift:
Es wurde im wesentlichen wie im Beispiel 5 verfahren, nur daß die Haftlackschicht kein Glyoxal enthielt. Die erhaltene Druckplatte wurde gleichfalls während 60 Sekunden bildmäßig belichtet und anschließend mit Wasser ausgewaschen.

Im Unterschied zu dem nach Beispiel 5 hergestellten Klischee waren bei dem Vergleichs-Klischee jedoch die feinen 50 µm dicken Linien und 5 %igen Rastertonwerte der Rasterlinienweite 36 Linien/cm nicht mehr einwandfrei mit dem Trägerblech verbunden. Wandte man eine Auswaschzeit von 140 Sekunden an, was einer 100 %igen Überwaschung entsprach, so traten auch bei den 100 µm breiten freistehenden Linien und selbst bei 10 %igen Rastertonwerten schwerste Haftungsmängel auf. Insgesamt erhielt man ein für den Druck völlig ungeeignetes Klischee.

### Beispiel 6

Herstellung eines mehrschichtigen, mit wäßrigen Medien entwickelbaren, lichtempfindlichen Aufzeichnungsmaterials mit einer thermisch vernetzten Haftlackschicht aus einem erfindungsgemäßen Gemisch; Herstellvorschrift:
Es wurde im wesentlichen wie im Beispiel 5 verfahren, nur daß die Haftlackschicht nicht durch Photopolymerisation, sondern bei 155°C während 2 Minuten thermisch vernetzt wurde.

Die weitere Verarbeitung der Druckplatte erfolgte wie in Beispiel 5 angegeben.

Das erhaltene Klischee eignete sich hervorragend zum Druck im indirekten Hochdruckverfahren. Auch seine feinsten Bildelemente wiesen eine hervorragende Haftung auf. Selbst eine Auswaschzeit von 140 Sekunden, was einer 100 %igen Überwaschung entsprach, führte zu keiner Beschädigung des Klischees durch Schichtablösung.

### Beispiel 7

Herstellung eines mehrschichtigen, mit wäßrigen Medien entwickelbaren, lichtempfindlichen Aufzeichnungsmaterials mit einer Haftlackschicht und einer reliefbildenden Schicht aus einem erfindungsgemäßen Gemisch; Herstellvorschrift:
Es wurde im wesentlichen wie in Beispiel 6 verfahren, nur daß zur Herstellung der reliefbildenden Schicht das erfindunsgemäße Gemisch aus Beispiel 1 verwendet wurde. Das erhaltene Klischee wies weder Lochfraß noch Haftungsmängel auf und war von ganz hervorragender Qualität. Das Klischee lieferte selbst nach sehr hohen Druckauflagen ausgezeichnete Druckergebnisse, und auch nach mehrfacher Verwendung wurden keinerlei Ablösungen von Reliefteilen beobachtet.

## Patentansprüche

1. Durch Photopolymerisation vernetzbares, in wäßrigen Medien lösliches oder dispergierbares Gemisch auf der Grundlage von Bindemittel, hiermit verträglichen photopolymerisierbaren Monomeren und Initiatoren der Photopolymerisation, wobei das Gemisch als Bindemittel zu 75 bis 95 % hydrolysierte Polyvinylalkoholalkancarbonsäureester und/oder Vinylalkohol-alkancarbonsäureester/Alkylenoxid-Pfropfmischpolymerisate sowie, bezogen auf die Gesamtmenge des Gemisches 0,1 bis 10 Gew.-% eines Aldehyds der allgemeinen Formel I enthält, 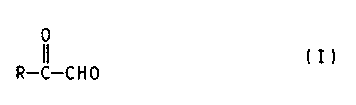 worin R ein Wasserstoffatom, eine Hydroxylgruppe oder einen C₁-C₆-Alkyl-, C₁-C₆-Alkoxi-, C₆-C₁₀-Aryl- oder einen C₆-C₁₀-Aryloxirest bedeutet.

2. Gemisch nach Anspruch 1, dadurch gekennzeichnet, daß der Aldehyd Glyoxal, Glyoxylsäure oder Glyoxylsäuremethylester ist.

3. Gemisch nach Anspruch 1 oder 2, dadurch gekennzeichnet, daß die Bindemittel seitenständige Alkencarbonsäureester-, Alkencarbonylamino-N-methylenether und/oder Carbamylesterreste enthalten.

4. Mehrschichtiges, mit wäßrigen Medien entwickelbares, lichtempfindliches Aufzeichnungsmaterial, dadurch gekennzeichnet, daß es mindestens eine Schicht aus einem Gemisch gemäß einem der Ansprüche 1 bis 3 enthält.

5. Mehrschichtiges, mit wäßrigen Medien entwickelbares, lichtempfindliches Aufzeichnungsmaterial nach Anspruch 4, dadurch gekennzeichnet, daß eine der Schichten eine 0,001 bis 0,8 mm dicke, reliefbildende Schicht ist.

6. Mehrschichtiges, mit wäßrigen Medien entwickelbares, lichtempfindliches Aufzeichnungsmateriai nach Anspruch 4, dadurch gekennzeichnet, daß eine der Schichten eine 0,0005 bis 0,1 mm dicke Haftlackschicht ist.

## Claims

1. A mixture which is crosslinkable by photopolymerization, soluble or dispersible in aqueous media and based on binders, photopolymerizable monomers compatible therewith and photopolymerization initiators, comprising, as binders, 75-95% hydrolyzed polyvinyl alkanecarboxylates and/or vinyl alkanecarboxylate alkylene oxide graft copolymers and from 0.1 to 10% by weight, based on the total amount of the mixture, of an aldehyde of the general formula I 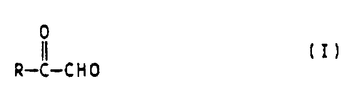 where R is hydrogen, hydroxyl, C₁-C₆-alkyl, C₁-C₆-alkoxy, C₆-C₁₀-aryl or C₆-C₁₀-aryloxy.

2. A mixture as claimed in claim 1, wherein the aldehyde is glyoxal, glyoxidic acid or methyl glyoxylate.

3. A mixture as claimed in claim 1 or 2, wherein the binders contain pendant alkenecarboxylate, alkenecarbonylamino-N-methylene ether and/or carbamoyl ester radicals.

4. A multilayer, photosensitive recording material which can be developed with aqueous media, comprising at least one layer of a mixture as claimed in any of claims 1 to 3.

5. A multilayer, photosensitive recording material which can be developed with aqueous media, as claimed in claim 4, wherein one of the layers is a 0.001-0.8 mm thick, relief-forming layer.

6. A multi-layer, photosensitive recording material which can be developed with aqueous media, as claimed in claim 4, wherein one of the layers is a 0.0005-0.1 mm thick layer of adhesive-forming components.

## Revendications

1. Mélange réticulable par photopolymérisation, soluble ou dispersable en milieu aqueux, à base de liant, de monomères photopolymérisables compatibles avec lui et d'initiateurs de photopolymérisation, le mélange contenant, comme liants des copolymérisats par greffage d'alcool polyvinylique hydrolisé à 75-95 % - ester d'acide alcanecarboxylique et/ou d'alcool vinylique - ester d'acide alcanecarboxylique/alkyleneoxyde ainsi que 0,1 à 10 % en poids, rapporte au points total du mélange, d'un aldéhyde de la formule générale I 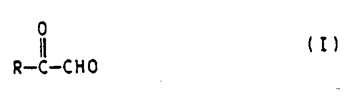 où R représente un atome d'hydrogène, un groupe hydroxyle ou un reste alkyle en C₁-C₆ alcoxy en C₁-C₆, aryle en C₆-C₁₀ ou (aryle en C₆-C₁₀)-oxy.

2. Mélange selon la revendication 1, caractérisé par le fait que l'aldéhyde est glyoxal, acide glyoxylique ou méthylate de glyoxyle.

3. Mélange selon la revendication 1 ou 2, caractérisé par le fait que les liants contiennent des restes latéraux d'ester d'acide alcènecarboxylique, d'éther alcénecarboxylamino-N-méthylène et/ou carbamylester.

4. Matériau d'enregistrement multicouche sensible à la lumière, développable avec des milieux aqueux, caractérisé par le fait qu'il contient au moins une couche d'un mélange selon l'une des revendications 1 à 3.

5. Matériau d'enregistrement multicouche sensible à la lumière, développable avec des milieux aqueux selon la revendication 4, caractérisé par le fait qu'une des couches est une couche formant relief, d'une épaisseur de 0,001 à 0,08 mm.

6. Matériau d'enregistrement multicouche sensible à la lumière, développable avec des milieux aqueux selon la revendication 4, caractérisé par le fait qu'une des couches est une couche de laque adhérante d'épaisseur de 0,005 à 0,1 mm.
